# EUROPEAN PATENT SPECIFICATION

(11) **EP 4 589 407 B1**
(45) Date of publication and mention of the grant of the patent: **22.04.2026**
(21) Application number: 24152582.3
(22) Date of filing: 18.01.2024
(51) Int. Cl.: G06F 1/20, F04D 29/44, F04D 29/58, H01L 23/467, H05K 7/20, H05K 5/00

(54) **HEAT SINK ASSEMBLY**
KÜHLKÖRPERANORDNUNG
ENSEMBLE DISSIPATEUR THERMIQUE

(43) Date of publication of application: 23.07.2025
(73) Proprietor: ABB SCHWEIZ AG, 5400 Baden (CH)
(72) Inventor: Karhunen, Antti, 00380 Helsinki (FI); Kastemäki, Pasi, 65320 Vaasa (FI); Pesonen, Asko, 00380 Helsinki (FI)
(74) Representative: Kolster Oy Ab

(56) References cited:
- EP-A2- 0 356 991
- CN-A- 116 520 954
- CN-Y- 201 097 304
- US-A1- 2005 041 391
- US-A1- 2005 113 016
- US-A1- 2008 062 641
- US-A1- 2008 239 661

## Description

### FIELD OF THE INVENTION

The present invention relates to a heat sink assembly comprising a heat sink and a cooling fan for providing a cooling air flow for cooling the heat sink.

### BACKGROUND OF THE INVENTION

A known heat sink assembly comprises a heat sink and a cooling fan such that the cooling fan is an axial-flow fan and a distance between the cooling fan and the heat sink is small.

One of the disadvantages associated with the above heat sink assembly is that due to the small distance between the cooling fan and the heat sink, a flow distribution at the heat sink is uneven. A centre of an impeller of the cooling fan generates practically no cooling air flow at all, and since the cooling air flow has not enough space to settle, a section of the heatsink adjacent to an axis of rotation of the impeller receives weaker air flow than sections of the heatsink farther from the axis of rotation.

Document US2005041391A1 discloses an electronics assembly with arrangement for air cooling.

### BRIEF DESCRIPTION OF THE INVENTION

An object of the present invention is to provide a heat sink assembly so as to alleviate the above disadvantage. The objects of the invention are achieved by a heat sink assembly which is characterized by what is stated in the independent claim. The preferred embodiments of the invention are disclosed in the dependent claims.

The invention is based on the idea of providing a heat sink assembly with an air deflector adapted to deflect at least part of a cooling air flow of a cooling fan in a lateral direction towards an axis of rotation of an impeller of the cooling fan.

An advantage of the heat sink assembly of the invention is that a section of the heatsink adjacent to the axis of rotation of the impeller receives stronger air flow than without the air deflector.

### BRIEF DESCRIPTION OF THE DRAWINGS

In the following the invention will be described in greater detail by means of preferred embodiments with reference to the attached drawings, in which
Figure 1 shows a heat sink assembly according to an embodiment of the invention;
Figures 2 to 4 show the heat sink assembly of Figure 1 from directions perpendicular to each other;
Figures 5 to 7 show an air deflector of the heat sink assembly of Figure 1 from directions perpendicular to each other;
Figure 8 shows a heat sink assembly according to another embodiment of the invention; and
Figure 9 shows the heat sink assembly of Figure 8 from a direction parallel to an axis of rotation of an impeller of a cooling fan of the heat sink assembly.

### DETAILED DESCRIPTION OF THE INVENTION

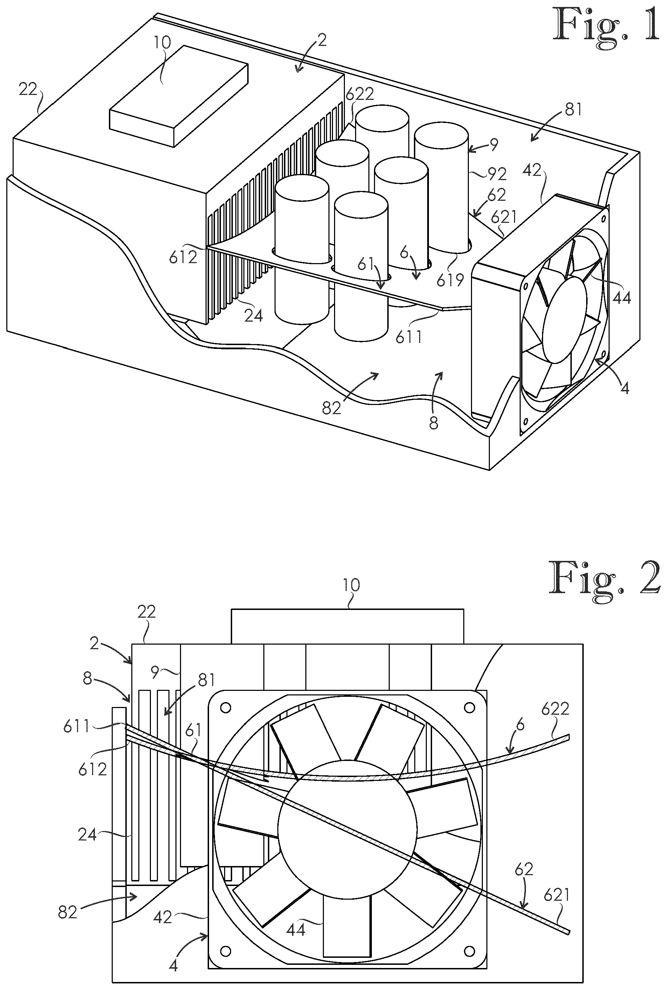

Figure 1 shows a heat sink assembly comprising a heat sink 2, a cooling fan 4 for providing a cooling air flow for cooling the heat sink 2, a flow channel 8 between the cooling fan 4 and the heat sink 2, an air deflector 6 in the flow channel 8, six capacitors 9 and a heat source 10.

The heat sink 2 comprises a body part 22 and a plurality of cooling fins 24 protruding from the body part 22 in a first direction. The body part 22 has a first surface on which the heat source 10 is installed, and a second surface facing opposite direction, wherein the plurality of cooling fins 24 protrude from the second surface. In Figure 1, the heat source 10 is on top of the body part 22 of the heat sink 2, and the cooling fins 24 extend downwards from the body part 22.

The cooling fan 4 is an axial-flow fan comprising a fan body 42 and an impeller 44 adapted to rotate relative to the fan body 42. The fan body 42 is immovably connected relative to the heat sink 2. A distance between the cooling fan 4 and the heat sink 2 in a second direction perpendicular to the first direction is a small distance. The second direction is parallel to an axis of rotation of the impeller 44. A majority of the cooling air flow is adapted to pass between the plurality of cooling fins 24. In an alternative embodiment, at least a portion of the cooling air flow is adapted to pass between the plurality of cooling fins.

A motor of the cooling fan 4 is located in the middle of the cooling fan 4. A diameter of the motor is more than 50 % of a diameter of the impeller 44, so a centre portion of the impeller 44 generates practically no cooling air flow at all. Regardless of the size of the motor, a cooling air flow generated by a centre portion of the impeller is always weak or non-existent.

The flow channel 8 is defined by flow channel walls. In Figure 1, one of the flow channel walls is omitted and another one is shown only partially in order to show components inside the flow channel 8. A cross section of the flow channel 8 has a form of a rectangle.

The air deflector 6 is adapted to deflect a part of the cooling air flow of the cooling fan 4 in lateral directions towards the axis of rotation of the impeller 44, wherein the lateral directions are parallel to a third direction perpendicular to both the first direction and the second direction. In the second direction, the air deflector 6 has a first end adjacent to the cooling fan 4, and a second end adjacent to the heat sink 2.

In an alternative embodiment the air deflector is adapted to deflect a part of the cooling air flow of the cooling fan in only one lateral direction towards the axis of rotation of the impeller.

The air deflector 6 divides the flow channel 8 into a first part 81 and a second part 82. In the first direction, a distance between the first part 81 of the flow channel 8 and the body part 22 of the heat sink 2 is smaller than a distance between the second part 82 of the flow channel 8 and the body part 22 of the heat sink 2. It can be said that in Figure 1, the first part 81 is an upper part, and the second part 82 is a lower part of the flow channel 8.

A cross-sectional area of the first part 81 of the flow channel 8 is larger in the first end adjacent to the cooling fan 4 than in the second end adjacent to the heat sink 2. In the first end of the flow channel 8, the cross-sectional area of the first part 81 is half of a total cross-sectional area of the flow channel 8. In the second end of the flow channel 8, the cross-sectional area of the first part 81 is one third of the total cross-sectional area of the flow channel 8.

The total cross-sectional area of the flow channel 8 is a sum of the cross-sectional areas of the first part 81 and the second part 82. The total cross-sectional area of the flow channel 8 is substantially the same through the entire length of the flow channel 8.

In an alternative embodiment, a ratio between the cross-sectional area of the first part of the flow channel in the second end and the cross-sectional area of the first part of the flow channel in the first end is in a range of 40 - 80 %.

The body part 22 of the heat sink 2 has a form of a rectangular parallelepiped. The body part 22 defines a body part plane, and the axis of rotation of the impeller 44 is parallel to the body part plane.

The body part 22 of the heat sink 2 is spaced apart from the axis of rotation of the impeller 44 in the first direction. The air deflector 6 is adapted to deflect a part of the cooling air flow of the cooling fan 4 towards the body part 22 of the heat sink 2 in the first direction. This deflection towards the body part 22 of the heat sink 2 is achieved by the fact that on average, the second end of the air deflector 6 is closer to the body part plane than the first end of the air deflector 6.

The capacitors 9 are located between the cooling fan 4 and the heat sink 2 in the second direction. Each of the capacitors 9 has a cylindrical body part 92 whose centre axis is perpendicular to the body part plane. In Figures, terminals of the capacitors 9 are omitted, as well as counterparts of said terminals.

The air deflector 6 is provided with six capacitor apertures 619 such that the cylindrical body part 92 of each of the capacitors 9 extends through the air deflector 6 via a corresponding capacitor aperture 619. In an alternative embodiment, the heat sink assembly does not comprise any capacitors extending through the air deflector.

Figure 2 shows the heat sink assembly of Figure 1 from a direction parallel to the second direction. In Figure 2, the first direction is a vertical direction, and the third direction is a horizontal direction.

In Figure 2, the air deflector 6 has been depicted only partially such that only cross-sectional surfaces at the first end and the second end of the air deflector 6 are shown. Further, in order to show said cross-sectional surfaces entirely, they are placed in front of all the other components of the assembly.

The air deflector 6 has a first lateral section 61 and a second lateral section 62 located on different sides of the axis of rotation of the impeller 44 in the third direction. In Figure 2, the first lateral section 61 is on the left, and the second lateral section 62 is on the right. In the first end of the air deflector 6 adjacent to the cooling fan 4, the first lateral section 61 is located closer to the body part plane than the second lateral section 62. In the first end of the air deflector 6, in the first direction, a ratio between a distance of a lateral edge of the second lateral section 62 from the body part 22 of the heat sink 2 and a distance of a lateral edge of the first lateral section 61 from the body part 22 of the heat sink 2 is approximately 700 %. In an alternative embodiment, said ratio is greater than or equal to 200 %.

In the first direction, a distance between a first end 611 and a second end 612 of the first lateral section 61 of the air deflector 6 is smaller than a distance between a first end 621 and a second end 622 of the second lateral section 62 of the air deflector 6, wherein the first and second ends are spaced apart in the second direction.

A dimension of the air deflector 6 in the first direction is approximately 80 % of the diameter of the impeller 44. In an alternative embodiment, a dimension of the air deflector in the first direction is greater than or equal to 40 % of a diameter of the impeller.

Figure 2 shows that the cross-sectional surface of the air deflector 6 at the first end has a rectilinear form while the cross-sectional surface of the air deflector 6 at the second end has a form of a chute such that in the first direction, lateral edges are closer to the body part 22 of the heat sink 2 than a middle portion of the cross-sectional surface.

When viewed in a direction parallel to the axis of rotation of the impeller 44, the impeller 44 is adapted to rotate towards the first lateral section 61 between the body part 22 of the heat sink 2 and the air deflector 6. In Figure 2, the impeller 44 is adapted to rotate anticlockwise.

The fact that the air deflector 6 is adapted to deflect a part of the cooling air flow of the cooling fan 4 in lateral directions towards the axis of rotation of the impeller 44 is achieved by a plurality of features of the air deflector 6. The above discussed chute form of the air deflector 6 at the second end provides a part of the deflection.

Further, a part of the deflection is provided by twisting the air flow in the first part 81 of the flow channel 8 around an axis parallel with the second direction. Said twisting of the air flow in the first part 81 is achieved since in the first direction, the distance between the first end 611 and the second end 612 of the first lateral section 61 of the air deflector 6 is smaller than the distance between the first end 621 and the second end 622 of the second lateral section 62 of the air deflector 6. Referring to Figure 2, in the direction of the cooling air flow, the second lateral section 62 of the air deflector 6 rises much more than the first lateral section 61 of the air deflector 6, thereby twisting the air flow anticlockwise and deflecting air flow from the right-hand side of the first part 81 towards the middle section of the first part 81. In fact, in the first direction, the second end 612 of the first lateral section 61 is slightly farther from the body part 22 than the first end 611 of the first lateral section 61.

A distance of the axis of rotation of the impeller 44 from the body part 22 of the heat sink 2 in the first direction is approximately the same as a radius of the impeller 44. In an alternative embodiment, a distance of the axis of rotation of the impeller from the body part of the heat sink in the first direction is greater than or equal to a radius of the impeller. In another alternative embodiment, the distance of the axis of rotation of the impeller from the body part of the heat sink in the first direction is smaller than or equal to 120 % of the radius of the impeller.

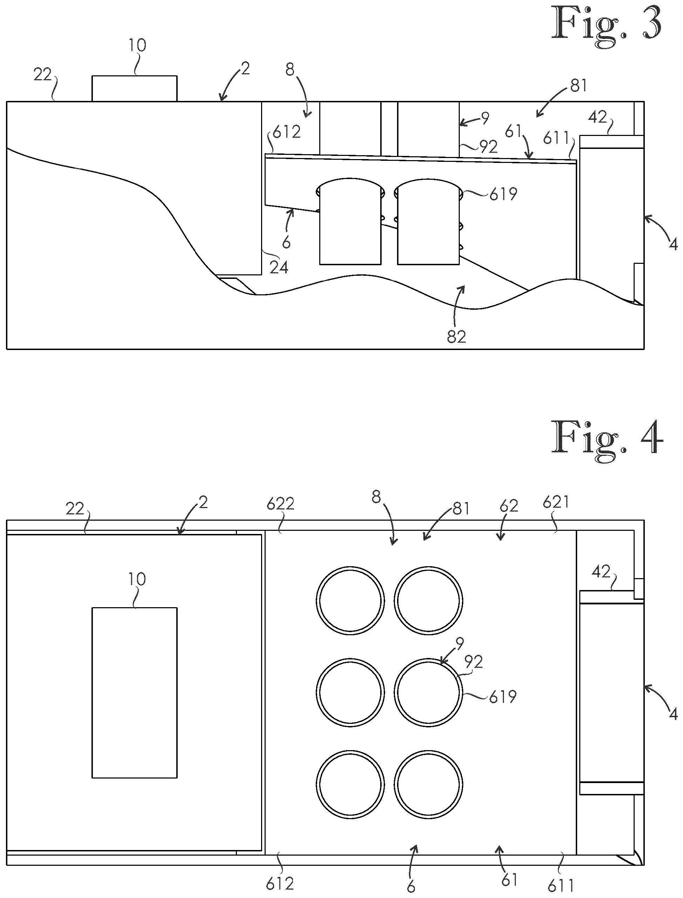

Figure 3 shows the heat sink assembly of Figure 1 from a direction parallel to the third direction. In Figure 3, the first direction is a vertical direction, and the second direction is a horizontal direction.

Figure 4 shows the heat sink assembly of Figure 1 from a direction parallel to the first direction. In Figure 4, the third direction is a vertical direction, and the second direction is a horizontal direction.

The small distance, which is a distance between the cooling fan 4 and the heat sink 2 in the second direction, is 20 cm. In an alternative embodiment, the small distance is in the range of 1 - 50 cm.

A ratio between the small distance and the diameter of the impeller 44 is approximately 160 %. In an alternative embodiment, a ratio between the small distance and a diameter of the impeller is in the range of 20-250 %.

A ratio between a longitudinal dimension of the air deflector 6 and the small distance is approximately 98 %, wherein the longitudinal dimension is parallel with the second direction. In an alternative embodiment, a ratio between the longitudinal dimension of the air deflector and the small distance is in the range of 80-100 %.

The air deflector 6 is adapted to hinder air flow between the first part 81 and the second part 82 of the flow channel 8 such that on a plane defined by the second direction and the third direction, a total surface area of projections of flow paths between the first part 81 and the second part 82 of the flow channel 8 is roughly 1 % of a surface area of a projection of the flow channel 8. The total surface area of projections of said flow paths includes gaps between the capacitors 9 and edges of the capacitor apertures 619. In an alternative embodiment, said total surface area of projections of flow paths between the first part and the second part of the flow channel is less than or equal to 15 % of a surface area of a projection of the flow channel.

Herein, the heat source is an electrical device that requires cooling. In an embodiment, the heat source comprises at least one semiconductor device. In the heat sink assembly shown in Figure 1, the heat source 10 is depicted as a single component having a form of a rectangular parallelepiped and located in the middle of the first surface of the body part 22. In an alternative embodiment, the heat source comprises a plurality of components having different shapes and placed asymmetrically on the first surface of the body part.

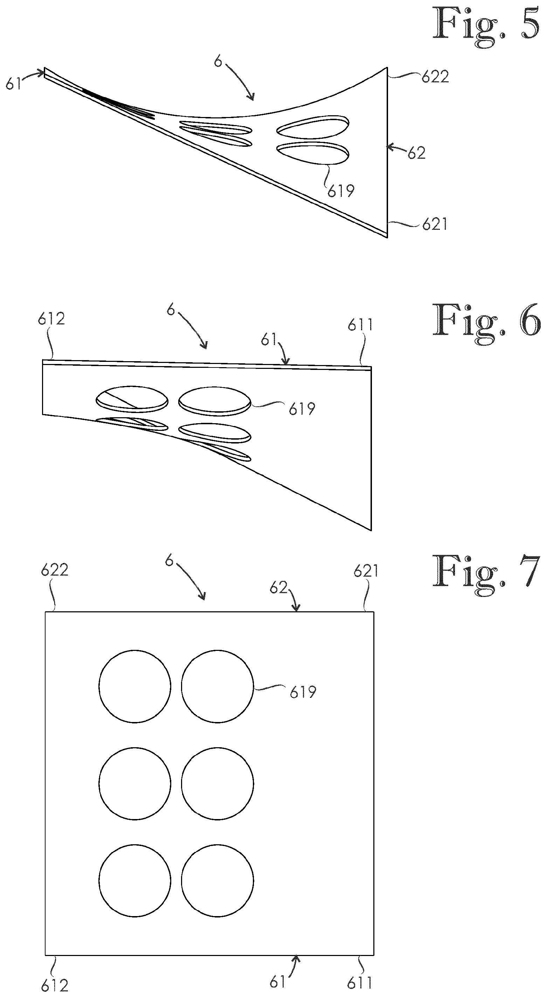

Figures 5 to 7 show the air deflector 6 from directions perpendicular to each other. Figure 5 shows the air deflector 6 from a direction parallel to the second direction. In Figure 5, the first direction is a vertical direction, and the third direction is a horizontal direction. Figure 6 shows the air deflector 6 from a direction parallel to the third direction. In Figure 6, the first direction is a vertical direction, and the second direction is a horizontal direction. Figure 7 shows the air deflector 6 from a direction parallel to the first direction. In Figure 7, the third direction is a vertical direction, and the second direction is a horizontal direction.

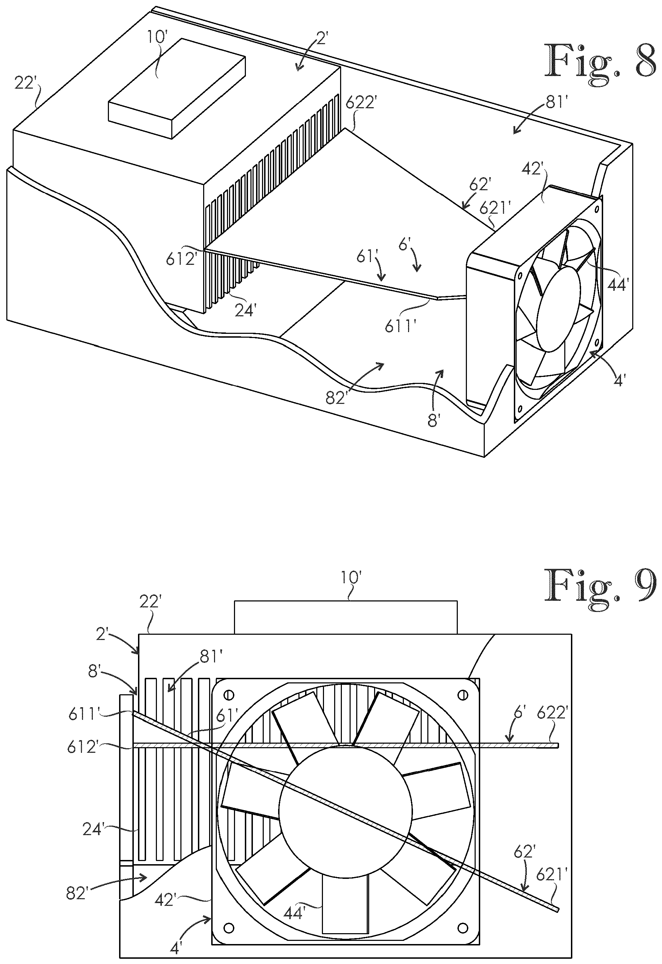

Figure 8 shows a heat sink assembly according to another embodiment of the invention. There are no capacitors in the heat sink assembly of Figure 8, and the air deflector 6' is different, but otherwise the heat sink assembly of Figure 8 is identical to the heat sink assembly shown in Figure 1.

Figure 9 shows the heat sink assembly of Figure 8 from a direction parallel to an axis of rotation of an impeller 44' of a cooling fan 4' of the heat sink assembly. In Figure 9, the heat sink assembly has been depicted according to the same principles as the heat sink assembly of Figure 1 is depicted in Figure 2.

The air deflector 6' divides the flow channel 8' into a first part 81' and a second part 82'. A cross-sectional area of the first part 81' of the flow channel 8' is larger in the first end adjacent to the cooling fan 4' than in the second end adjacent to the heat sink 2'. In the first end of the flow channel 8', the cross-sectional area of the first part 81' is half of a total cross-sectional area of the flow channel 8'. In the second end of the flow channel 8', the cross-sectional area of the first part 81' is one third of the total cross-sectional area of the flow channel 8'.

At a first end of the air deflector 6' adjacent to the cooling fan 4', the first lateral section 61' is located closer to the body part plane than the second lateral section 62'.

A cross-sectional surface of the air deflector 6' has a rectilinear form on any plane perpendicular to the second direction. At the second end of the air deflector 6', the rectilinear cross-sectional surface of the air deflector 6' is parallel to the body part plane. At the first end of the air deflector 6', the rectilinear cross-sectional surface of the air deflector 6' is at an angle of 25° relative to the body part plane. In the first direction, the second end 612' of the first lateral section 61' is slightly farther from the body part 22' than the first end 611' of the first lateral section 61'.

Referring to Figure 9, in the direction of the cooling air flow, the second lateral section 62' of the air deflector 6' rises substantially while the first lateral section 61' of the air deflector 6' slightly descends, thereby twisting the air flow anticlockwise and deflecting air flow from the right-hand side of the first part 81' towards the middle section of the first part 81'.

It will be obvious to a person skilled in the art that the scope of the claimed invention can be implemented in various ways. The invention and its embodiments are not limited to the examples described above but may vary within the scope of the claims.

## Claims

1. A heat sink assembly comprising:
a heat sink (2) comprising a body part (22) and a plurality of cooling fins (24) protruding from the body part (22) in a first direction;
a cooling fan (4) for providing a cooling air flow for cooling the heat sink (2), wherein the cooling fan (4) is an axial-flow fan comprising a fan body (42) and an impeller (44) adapted to rotate relative to the fan body (42), wherein a distance between the cooling fan (4) and the heat sink (2) in a second direction perpendicular to the first direction is a small distance, wherein at least a portion of the cooling air flow is adapted to pass between the plurality of cooling fins (24),
wherein the heat sink assembly comprises an air deflector (6) adapted to deflect at least part of the cooling air flow of the cooling fan (4) in a lateral direction towards an axis of rotation of the impeller (44), wherein the lateral direction is parallel to a third direction perpendicular to both the first direction and the second direction,
wherein the body part (22) of the heat sink (2) is spaced apart from the axis of rotation of the impeller (44) in the first direction, and the air deflector (6) is adapted to deflect at least part of the cooling air flow of the cooling fan (4) towards the body part (22) of the heat sink (2) in the first direction,
**characterized in that** the heat sink assembly comprises a flow channel (8) between the cooling fan (4) and the heat sink (2), wherein the flow channel (8) is defined by flow channel walls, and wherein the air deflector (6) divides the flow channel (8) into a first part (81) and a second part (82), wherein in the first direction, a distance between the first part (81) and the body part (22) of the heat sink (2) is smaller than a distance between the second part (82) and the body part (22) of the heat sink (2).

2. The heat sink assembly according to claim 1, wherein the body part (22) of the heat sink (2) defines a body part plane, and the axis of rotation of the impeller (44) is parallel to the body part plane.

3. The heat sink assembly according to claim 2, wherein a distance of the axis of rotation of the impeller (44) from the body part (22) of the heat sink (2) in the first direction is greater than or equal to a radius of the impeller (44).

4. The heat sink assembly according to claim 3, wherein the distance of the axis of rotation of the impeller (44) from the body part (22) of the heat sink (2) in the first direction is smaller than or equal to 120 % of the radius of the impeller (44).

5. The heat sink assembly according to any one of the preceding claims, wherein the small distance is in the range of 1 - 40 cm.

6. The heat sink assembly according to any one of the preceding claims, wherein a ratio between the small distance and a diameter of the impeller (44) is in the range of 20-250 %.

7. The heat sink assembly according to any one of the preceding claims, wherein a ratio between a longitudinal dimension of the air deflector (6) and the small distance is in the range of 80-100 %, wherein the longitudinal dimension is parallel with the second direction.

8. The heat sink assembly according to any one of the preceding claims, wherein a dimension of the air deflector (6) in the first direction is greater than or equal to 50 % of a diameter of the impeller (44).

9. The heat sink assembly according to claim 2, wherein the air deflector (6) has a first lateral section (61) and a second lateral section (62) located on different sides of the axis of rotation of the impeller (44) in the third direction, wherein in a first end of the air deflector (6) adjacent to the cooling fan (4), the first lateral section (61) is located closer to the body part plane than the second lateral section (62), wherein when viewed in a direction parallel to the axis of rotation of the impeller (44), the impeller (44) is adapted to rotate towards the first lateral section (61) between the body part (22) of the heat sink (2) and the air deflector (6).

10. The heat sink assembly according to claim 9, wherein in the first direction, a distance between first (611) and second (612) ends of the first lateral section (61) of the air deflector (6) is smaller than a distance between first (621) and second ends (622) of the second lateral section (62) of the air deflector (6), wherein the first and second ends are spaced apart in the second direction.

11. The heat sink assembly according to any one of the preceding claims, wherein a cross-sectional area of the first part (81) of the flow channel (8) is larger in a first end adjacent to the cooling fan (4) than in a second end adjacent to the heat sink (2).

12. The heat sink assembly according to any one of the preceding claims, wherein the air deflector (6) is adapted to hinder air flow between the first part (81) and the second part (82) of the flow channel (8) such that on a plane defined by the second direction and the third direction, a total surface area of projections of flow paths between the first part (81) and the second part (82) of the flow channel (8) is less than or equal to 15 % of a surface area of a projection of the flow channel (8).

13. The heat sink assembly according to any one of the preceding claims, wherein the body part (22) of the heat sink (2) defines a body part plane, and the axis of rotation of the impeller (44) is parallel to the body part plane, wherein the heat sink assembly comprises a plurality of capacitors (9) located between the cooling fan (4) and the heat sink (2) in the second direction, wherein each of the plurality of capacitors (9) has a cylindrical body part (92) whose centre axis is perpendicular to the body part plane, wherein the air deflector (6) is provided with a plurality of capacitor apertures such that the cylindrical body part (92) of each of the plurality of capacitors (9) extends through the air deflector (6) via a corresponding capacitor aperture (619).

## Patentansprüche

1. Kühlkörperanordnung, umfassend:
einen Kühlkörper (2), umfassend einen Körperabschnitt (22) und eine Vielzahl von Kühlrippen (24), die sich von dem Körperabschnitt (22) in eine erste Richtung erstrecken;
einen Kühllüfter (4) zum Bereitstellen eines Kühlluftstroms zum Kühlen des Kühlkörpers (2), wobei der Kühllüfter (4) ein Axiallüfter ist, der einen Lüfterkörper (42) und ein Laufrad (44) umfasst, das dazu ausgelegt ist, sich relativ zum Lüfterkörper (42) zu drehen, wobei ein Abstand zwischen dem Kühllüfter (4) und dem Kühlkörper (2) in einer zweiten Richtung senkrecht zur ersten Richtung ein kleiner Abstand ist, wobei mindestens ein Teil des Kühlluftstroms dazu ausgelegt ist, zwischen der Vielzahl von Kühlrippen (24) hindurchzuströmen,
wobei die Kühlkörperanordnung einen Luftablenker (6) umfasst, der dazu ausgelegt ist, mindestens einen Teil des Kühlluftstroms des Kühllüfters (4) in eine Querrichtung zu lenken, die auf eine Rotationsachse des Laufrads (44) gerichtet ist, wobei die Querrichtung parallel zu einer dritten Richtung verläuft, die sowohl zur ersten Richtung als auch zur zweiten Richtung senkrecht ist,
wobei der Körperabschnitt (22) des Kühlkörpers (2) in der ersten Richtung von der Rotationsachse des Laufrads (44) beabstandet ist und der Luftablenker (6) dazu ausgelegt ist, mindestens einen Teil des Kühlluftstroms des Kühllüfters (4) in der ersten Richtung auf den Körperabschnitt (22) des Kühlkörpers (2) zu lenken,
**dadurch gekennzeichnet, dass** die Kühlkörperanordnung einen Strömungskanal (8) zwischen dem Kühllüfter (4) und dem Kühlkörper (2) umfasst, wobei der Strömungskanal (8) durch Strömungskanalwände definiert ist, und wobei der Luftablenker (6) den Strömungskanal (8) in einen ersten Teil (81) und einen zweiten Teil (82) unterteilt, wobei in der ersten Richtung ein Abstand zwischen dem ersten Teil (81) und dem Körperabschnitt (22) des Kühlkörpers (2) kleiner ist als ein Abstand zwischen dem zweiten Teil (82) und dem Körperabschnitt (22) des Kühlkörpers (2).

2. Kühlkörperanordnung nach Anspruch 1, wobei der Körperabschnitt (22) des Kühlkörpers (2) eine Körperabschnittsebene definiert und die Rotationsachse des Laufrads (44) parallel zur Körperabschnittsebene verläuft.

3. Kühlkörperanordnung nach Anspruch 2, wobei ein Abstand der Rotationsachse des Laufrads (44) vom Körperabschnitt (22) des Kühlkörpers (2) in der ersten Richtung größer oder gleich einem Radius des Laufrads (44) ist.

4. Kühlkörperanordnung nach Anspruch 3, wobei der Abstand der Rotationsachse des Laufrads (44) vom Körperabschnitt (22) des Kühlkörpers (2) in der ersten Richtung kleiner oder gleich 120 % des Radius des Laufrads (44) ist.

5. Kühlkörperanordnung nach einem der vorhergehenden Ansprüche, wobei der kleine Abstand im Bereich von 1 - 40 cm liegt.

6. Kühlkörperanordnung nach einem der vorhergehenden Ansprüche, wobei ein Verhältnis zwischen dem kleinen Abstand und einem Durchmesser des Laufrads (44) im Bereich von 20-250 % liegt.

7. Kühlkörperanordnung nach einem der vorhergehenden Ansprüche, wobei ein Verhältnis zwischen einer Längsabmessung des Luftablenkers (6) und dem kleinen Abstand im Bereich von 80-100 % liegt, wobei die Längsabmessung parallel zur zweiten Richtung ist.

8. Kühlkörperanordnung nach einem der vorhergehenden Ansprüche, wobei eine Abmessung des Luftablenkers (6) in der ersten Richtung größer oder gleich 50 % eines Durchmessers des Laufrads (44) ist.

9. Kühlkörperanordnung nach Anspruch 2, wobei der Luftablenker (6) einen ersten seitlichen Abschnitt (61) und einen zweiten seitlichen Abschnitt (62) aufweist, die in der dritten Richtung auf gegenüberliegenden Seiten der Rotationsachse des Laufrads (44) angeordnet sind, wobei an einem ersten Ende des Luftablenkers (6), das an den Kühllüfter (4) angrenzt, der erste seitliche Abschnitt (61) näher an der Körperabschnittsebene liegt als der zweite seitliche Abschnitt (62), wobei, in einer Richtung parallel zur Rotationsachse des Laufrads (44) betrachtet, das Laufrad (44) dazu ausgelegt ist, sich zwischen dem Körperabschnitt (22) des Kühlkörpers (2) und dem Luftablenker (6) in Richtung des ersten seitlichen Abschnitts (61) zu drehen.

10. Kühlkörperanordnung nach Anspruch 9, wobei in der ersten Richtung ein Abstand zwischen einem ersten (611) und einem zweiten (612) Ende des ersten seitlichen Abschnitts (61) des Luftablenkers (6) kleiner als ein Abstand zwischen einem ersten (621) und einem zweiten Ende (622) des zweiten seitlichen Abschnitts (62) des Luftablenkers (6) ist, wobei das erste und das zweite Ende in der zweiten Richtung beabstandet sind.

11. Kühlkörperanordnung nach einem der vorhergehenden Ansprüche, wobei eine Querschnittsfläche des ersten Teils (81) des Strömungskanals (8) in einem ersten Ende angrenzend an den Kühllüfter (4) größer ist als in einem zweiten Ende angrenzend an den Kühlkörper (2).

12. Kühlkörperanordnung nach einem der vorhergehenden Ansprüche, wobei der Luftablenker (6) dazu ausgelegt ist, einen Luftstrom zwischen dem ersten Teil (81) und dem zweiten Teil (82) des Strömungskanals (8) derart zu behindern, dass auf einer Ebene, die durch die zweite Richtung und die dritte Richtung definiert ist, eine Gesamtfläche von Vorsprüngen von Strömungswegen zwischen dem ersten Teil (81) und dem zweiten Teil (82) des Strömungskanals (8) kleiner oder gleich 15 % einer Fläche eines Vorsprungs des Strömungskanals (8) ist.

13. Kühlkörperanordnung nach einem der vorhergehenden Ansprüche, wobei der Körperabschnitt (22) des Kühlkörpers (2) eine Körperabschnittsebene definiert und die Rotationsachse des Laufrads (44) parallel zu der Körperabschnittsebene ist, wobei die Kühlkörperanordnung eine Vielzahl von Kondensatoren (9) umfasst, die sich zwischen dem Kühllüfter (4) und dem Kühlkörper (2) in der zweiten Richtung befinden, wobei jeder der Vielzahl von Kondensatoren (9) einen zylindrischen Körperabschnitt (92) aufweist, dessen Mittelachse senkrecht zur Körperabschnittsebene ist, wobei der Luftablenker (6) mit einer Vielzahl von Kondensatoröffnungen versehen ist, sodass sich der zylindrische Körperabschnitt (92) jedes der Vielzahl von Kondensatoren (9) durch den Luftablenker (6) über eine entsprechende Kondensatoröffnung (619) erstreckt.

## Revendications

1. Ensemble dissipateur thermique comprenant :
un dissipateur thermique (2) comprenant une partie corps (22) et une pluralité d'ailettes de refroidissement (24) faisant saillie à partir de la partie corps (22) dans une première direction ;
un ventilateur de refroidissement (4) pour fournir un flux d'air de refroidissement pour refroidir le dissipateur thermique (2), le ventilateur de refroidissement (4) étant un ventilateur à flux axial comprenant un corps de ventilateur (42) et une hélice (44) adaptée pour tourner par rapport au corps de ventilateur (42), une distance entre le ventilateur de refroidissement (4) et le dissipateur thermique (2) dans une deuxième direction perpendiculaire à la première direction étant une faible distance, au moins une partie du flux d'air de refroidissement étant adaptée pour passer entre la pluralité d'ailettes de refroidissement (24),
l'ensemble dissipateur thermique comprenant un déflecteur d'air (6) conçu pour dévier au moins une partie du flux d'air de refroidissement du ventilateur de refroidissement (4) dans une direction latérale vers un axe de rotation de l'hélice (44), la direction latérale étant parallèle à une troisième direction perpendiculaire à la fois à la première direction et à la deuxième direction,
la partie corps (22) du dissipateur thermique (2) étant espacée de l'axe de rotation de l'hélice (44) dans la première direction, et le déflecteur d'air (6) étant adapté pour dévier au moins une partie du flux d'air de refroidissement du ventilateur de refroidissement (4) vers la partie corps (22) du dissipateur thermique (2) dans la première direction,
**caractérisé en ce que** l'ensemble dissipateur thermique comporte un canal d'écoulement (8) entre le ventilateur de refroidissement (4) et le dissipateur thermique (2),
le canal d'écoulement (8) étant défini par des parois de canal d'écoulement, et le déflecteur d'air (6) divisant le canal d'écoulement (8) en une première partie (81) et une seconde partie (82), une distance entre la première partie (81) et la partie corps (22) du dissipateur thermique (2), dans la première direction, étant inférieure à une distance entre la seconde partie (82) et la partie corps (22) du dissipateur thermique (2).

2. Ensemble dissipateur thermique selon la revendication 1, dans lequel la partie corps (22) du dissipateur thermique (2) définit un plan de partie corps, et l'axe de rotation de l'hélice (44) est parallèle au plan de partie corps.

3. Ensemble dissipateur thermique selon la revendication 2, dans lequel une distance de l'axe de rotation de l'hélice (44) par rapport à la partie corps (22) du dissipateur thermique (2) dans la première direction est supérieure ou égale à un rayon de l'hélice (44).

4. Ensemble dissipateur thermique selon la revendication 3, dans lequel la distance de l'axe de rotation de l'hélice (44) par rapport à la partie corps (22) du dissipateur thermique (2) dans la première direction est inférieure ou égale à 120 % du rayon de l'hélice (44) .

5. Ensemble dissipateur thermique selon l'une quelconque des revendications précédentes, dans lequel la faible distance est dans la plage de 1 à 40 cm.

6. Ensemble dissipateur thermique selon l'une quelconque des revendications précédentes, dans lequel un rapport entre la faible distance et un diamètre de l'hélice (44) est dans la plage de 20 à 250 %.

7. Ensemble dissipateur thermique selon l'une quelconque des revendications précédentes, dans lequel un rapport entre une dimension longitudinale du déflecteur d'air (6) et la faible distance est dans la plage de 80 à 100 %, dans lequel la dimension longitudinale est parallèle à la deuxième direction.

8. Ensemble dissipateur thermique selon l'une quelconque des revendications précédentes, dans lequel une dimension du déflecteur d'air (6) dans la première direction est supérieure ou égale à 50 % d'un diamètre de l'hélice (44) .

9. Ensemble dissipateur thermique selon la revendication 2, dans lequel le déflecteur d'air (6) a une première section latérale (61) et une seconde section latérale (62) situées sur des côtés différents de l'axe de rotation de l'hélice (44) dans la troisième direction, dans lequel, dans une première extrémité du déflecteur d'air (6) adjacente au ventilateur de refroidissement (4), la première section latérale (61) est située plus près du plan de partie de corps que la seconde section latérale (62), dans lequel, en regardant dans une direction parallèle à l'axe de rotation de l'hélice (44), l'hélice (44) est adaptée pour tourner vers la première section latérale (61) entre la partie corps (22) du dissipateur thermique (2) et le déflecteur d'air (6).

10. Ensemble dissipateur thermique selon la revendication 9, dans lequel, dans la première direction, une distance entre les première (611) et seconde (612) extrémités de la première section latérale (61) du déflecteur d'air (6) est inférieure à une distance entre les première (621) et seconde (622) extrémités de la seconde section latérale (62) du déflecteur d'air (6), dans lequel les première et seconde extrémités sont espacées dans la deuxième direction.

11. Ensemble dissipateur thermique selon l'une quelconque des revendications précédentes, dans lequel une aire de section transversale de la première partie (81) du canal d'écoulement (8) est plus grande dans une première extrémité adjacente au ventilateur de refroidissement (4) que dans une seconde extrémité adjacente au dissipateur thermique (2).

12. Ensemble dissipateur thermique selon l'une quelconque des revendications précédentes, dans lequel le déflecteur d'air (6) est conçu pour empêcher un écoulement d'air entre la première partie (81) et la seconde partie (82) du canal d'écoulement (8) de telle sorte que, sur un plan défini par la deuxième direction et la troisième direction, une surface totale de projections de chemins d'écoulement entre la première partie (81) et la seconde partie (82) du canal d'écoulement (8) soit inférieure ou égale à 15 % d'une surface d'une projection du canal d'écoulement (8).

13. Ensemble dissipateur thermique selon l'une quelconque des revendications précédentes, dans lequel la partie corps (22) du dissipateur thermique (2) définit un plan de partie corps, et l'axe de rotation de l'hélice (44) est parallèle au plan de partie corps, l'ensemble dissipateur thermique comprenant une pluralité de condensateurs (9) situés entre le ventilateur de refroidissement (4) et le dissipateur thermique (2) dans la deuxième direction, chacun des condensateurs (9) présentant une partie corps cylindrique (92) dont l'axe central est perpendiculaire au plan de partie corps, le déflecteur d'air (6) étant pourvu d'une pluralité d'ouvertures pour condensateurs de sorte que la partie corps cylindrique (92) de chacun des condensateurs (9) s'étende à travers le déflecteur d'air (6) en passant par une ouverture pour condensateur (619) correspondante.
